# EUROPÄISCHE PATENTANMELDUNG

(11) **EP 1 199 914 A2**
(43) Veröffentlichungstag der Anmeldung: **24.04.2002**
(21) Anmeldenummer: 01122735.2
(22) Anmeldetag: 21.09.2001
(51) Int. Cl.: H05K 3/30

(54) **Elektrische Baugruppe mit einer Haltevorrichtung und einem daran festgelegten elektrischen Bauelement**

(30) Priorität: 18.10.2000 DE 10051560
(71) Anmelder: ROBERT BOSCH GMBH, 70442 Stuttgart (DE)
(72) Erfinder: Jakob, Gert, 70378 Stuttgart (DE); Bohmwetsch, Gerd, 71672 Marbach (DE); Eckert, Bernd, 71665 Vaihingen/Enz (DE)

(57) **Zusammenfassung**

Die Erfindung betrifft eine elektrische Baugruppe, umfassend eine auf einem Trägersubstrat mechanisch befestigbare Haltevorrichtung mit wenigstens einer Stützfläche zur Auflage auf das Trägersubstrat und ein an der Haltevorrichtung festgelegtes elektrisches Bauelement mit wenigstens einem Anschlußelement, das mit einem an der wenigstens einen Stützfläche angeordneten Kontaktteil der Baugruppe elektrisch leitend verbunden ist. Es wird vorgeschlagen, das Kontaktteil durch einen abgebogenen Abschnitt des wenigstens einen Anschlußelementes des elektrischen Bauelementes zu bilden, welcher Abschnitt an der Stützfläche angeordnet ist.

## Beschreibung

Die Erfindung betrifft eine elektrische Baugruppe mit einer Haltevorrichtung und einem daran festgelegten elektrischen Bauelement nach dem Oberbegriff des Anspruchs 1.

Es ist bekannt, relativ schwere elektrische Bauelemente, wie beispielsweise große Kondensator-Bauelemente, mittels einer Haltevorrichtung auf ein Trägersubstrat, beispielsweise eine Leiterplatte, aufzubringen. Die aus der Haltevorrichtung und dem elektrischen Bauelement bestehende Baugruppe kann dann in einfacher Weise, beispielsweise in SMD-Technik (Surface Mounted Device) auf die Leiterplatte aufgebracht werden. Eine derartige Baugruppe ist beispielsweise aus der DE 198 14 156 C1 bekannt, welche eine elektrische Baugruppe mit einer rahmenartigen Haltevorrichtung mit einer zentralen Öffnung zeigt, in die ein elektrisches Bauelement eingesetzt ist. Bei dem elektrischen Bauelement handelt es sich um einen Kondensator, dessen Anschlußelemente mit leitenden Kontaktflächen des Halterahmens verbunden sind. Die Kontaktflächen sind wiederum über leitende Abschnitte des Halterahmens jeweils mit einem Kontaktteil auf der Unterseite des Halterahmens leitend verbunden. Bei der Montage der Baugruppe auf der Leiterplatte werden die Kontaktteile der Baugruppe in SMD-Technik auf zugeordnete Leiterbahnen der Leiterplatte aufgelötet, so daß das elektrische Bauelement mit den Leiterbahnen der Leiterplatte elektrisch verbunden ist. Nachteilig dabei ist, daß die Bauelemente zunächst mit dem Halterahmen verlötet werden müssen und anschließend ein erneuter Lötprozeß notwendig ist, um die Kontaktteile des Halterahmens mit den Leiterbahnen zu verlöten. Außerdem ist nachteilig daß die Lötstellen zwischen den Kontaktteilen der Baugruppe und den Leiterbahnen der Leiterplatte zugleich zur mechanischen Befestigung der Baugruppe dienen, da dann Vibrations- und Schüttelbelastungen, wie sie beispielsweise in einem Kfz auftreten, unmittelbar auf die Lötstellen übertragen werden. Eine Beschädigung der Lötstellen und eine Beeinträchtigung der elektrischen Verbindung zwischen dem Bauelement und der Leiterplatte kann daher nicht ausgeschlossen werden.

### Vorteile der Erfindung

Bei der erfindungsgemäßen elektrischen Baugruppe mit den kennzeichnenden Merkmalen des Anspruchs 1 werden die im Stand der Technik bekannten Nachteile vermieden. Dadurch, daß das Kontaktteil durch einen an der Stützfläche angeordneten abgebogenen Abschnitt des wenigstens einen Anschlußelementes des elektrischen Bauelementes gebildet wird, kann die mechanische Befestigung von der elektrischen Verbindung des Bauelementes mit der Leiterplatte getrennt werden. Da die der mechanischen Befestigung dienende Haltevorrichtung keine elektrischen Leitungsteile aufweist, können Schüttelbelastungen und Vibrationsbelastungen, die auf die Haltevorrichtung übertragen werden, von den elektrischen Verbindungsstellen abgehalten werden. Weiterhin kann die Baugruppe als vormontierte Einheit auf das Trägersubstrat bestückt werden. Die Festlegung des elektrischen Bauelementes an der Haltevorrichtung ist besonders leicht durchführbar, da das Bauelement nur in die Haltevorrichtung eingesetzt und anschließend die Anschlußelemente des Bauelementes an der Haltevorrichtung umgebogen werden. Ein zusätzlicher Lötprozeß ist also nicht erforderlich. Darüber hinaus wird durch die spezielle Lage der abgebogenen Enden der Anschlußelemente erreicht, daß bei der Aufbringung der elektrischen Baugruppe auf ein Trägersubstrat die an der Stützfläche angeordneten abgebogenen Abschnitte der Anschlußelemente zuverlässig mit den Leiterbahnen des Trägersubstrats kontaktiert werden können.

Vorteilhafte Ausführungsbeispiele und Weiterbildungen der Erfindung werden durch die in den Unteransprüchen enthaltenen Merkmale ermöglicht.

Ein besonders sicherer Halt der Baugruppe auf dem Trägersubstrat wird dadurch erreicht, daß die Haltevorrichtung mittels schraubbarer Befestigungsmittel an dem Trägersubstrat mechanisch befestigbar ist.

Vorteilhaft ist der abgebogene Abschnitt des wenigstens einen Anschlußelementes parallel zur Stützfläche der Haltevorrichtung verlaufend zumindest teilweise in einer Aussparung der Stützfläche angeordnet, wodurch die Gefahr einer Beschädigung der Anschlußelemente bei der Aufbringung der Baugruppe auf ein Trägersubstrat vermieden wird.

Dadurch, daß der abgebogene Abschnitt des wenigstens einen Anschlußelementes im nicht montierten Zustand der Baugruppe mit einem Teil ein Stück von der Stützfläche nach außen absteht, wird bei der Montage der Baugruppe eine sicherer Kontaktierung des Anschlußelementes mit Leiterbahnen des Trägersubstrats ermöglicht.

Besonders vorteilhaft ist, daß der im nicht montierten Zustand der Baugruppe von der Stützfläche abstehende Teil des abgebogenen Abschnitts des wenigstens einen Anschlußelementes bei Auflage auf das ebene Trägersubstrat in der Aussparung versenkbar ist. Durch diese Maßnahme ist es möglich, die Stützfläche der Haltevorrichtung beispielsweise mittels schraubbaren Befestigungsmitteln mit großer Kraft auf das Trägersubstrat aufzudrücken und so eine besonders feste mechanische Verbindung zu realisieren, ohne daß die elektrischen Verbindungsstellen belastet werden. Zu diesem Zwecke weisen die Aussparungen in der Stützfläche der Haltevorrichtung eine Tiefe und Breite auf, die größer bemessen ist als der Durchmesser des abgebogenen Abschnitts des Anschlußelementes.

Ein besonders leichter Zusammenbau der Baugruppe wird vorteilhaft dadurch möglich, daß die Haltevorrichtung zwei räumlich getrennte Halteteile mit jeweils einer Stützfläche umfaßt, wobei die beiden Halteteile getrennt voneinander an den stirnseitigen Enden eines langgestreckten elektrischen Bauelementes, beispielsweise eines Kondensators, befestigbar sind. So können beispielsweise große zylindrische Kondensatoren mit zum Trägersubstrat parallel ausgerichteter Achse auf das Trägersubstrat aufgebracht werden.

Vorteilhaft weisen die beiden Halteteile elastisch biegsame Klemmittel zur Festlegung des elektrischen Bauelementes auf.

Weiterhin ist vorteilhaft, daß jedes Halteteil einen becherförmigen Grundkörper mit einer Grundplatte und einer umlaufenden Seitenwand aufweist. Die stirnseitigen Enden des elektrischen Bauelementes können in die becherförmigen Grundkörper eingeführt werden. Durch geeignete Wahl des Abstandes zwischen der Stützfläche und der becherförmigen Aufnahme für das Bauelement ist es möglich, unter dem elektrischen Bauelement noch andere Bauelemente auf dem Trägersubstrat anzuordnen.

Vorteilhaft können die Seitenwände der beiden Halteteile durch schlitzartige Ausnehmungen in mehrere Klemmlappen unterteilt werden, wodurch eine zuverlässige und stabile Festlegung des elektrischen Bauelementes an der Haltevorrichtung ermöglicht wird.

Weiterhin ist vorteilhaft, wenn jedes Halteteil auf der von dem Bauelement abgewandten Seite einen Vorsprung aufweist, der eine sich parallel zur Grundplatte und senkrecht zur Stützfläche des jeweiligen Halteteils erstreckende Durchgangsöffnung zur Durchführung einer Schraube aufweist.

Dadurch, daß jedes Halteteil einen von der Stützfläche abstehenden Zentrierzapfen zur Einführung in eine Ausnehmung des Trägersubstrats aufweist, ist es möglich, die Baugruppe zunächst mittels der Zentrierzapfen an dem Trägersubstrat festzulegen und anschließend eine Lötverbindung der Anschlußelemente mit dem Trägersubstrat herzustellen und die Baugruppe über schraubbare Befestigungsmittel mit dem Trägersubstrat zu verbinden.

Vorteilhaft ist wenigstens ein Halteteil der Baugruppe mit wenigstens einem Durchbruch versehen, welcher der Durchführung des wenigstens einen von dem stirnseitigen Ende des elektrischen Bauelementes abstehenden Anschlußelementes dient. Nach dem Einschieben des Bauelementes in die becherförmigen Halteteile, kann das wenigstens eine Anschlußelement hinter dem Durchbruch zur Stützfläche hin abgebogen und in der Ebene der Stützfläche erneut abgebogen werden. Diese Maßnahmen sind in einer automatisierten Linienfertigung ohne größeren Aufwand kostengünstig durchführbar.

### Zeichnungen

Ausführungsbeispiele der Erfindung sind in den Zeichnungen dargestellt und werden in der nachfolgenden Beschreibung erläutert. Es zeigt
Fig. 1 eine perspektivische Ansicht der elektrischen Baugruppe mit der Haltevorrichtung und einem Kondensator,
Fig. 2 eine Innenansicht eines der Halteteile,
Fig. 3a und 3b einen Querschnitt durch eine Detailansicht der Baugruppe während der Bestückung auf einem Trägersubstrat,
Fig. 4 eine Teilansicht eines Steuergerätes mit einer Leiterplatte und einer an der Leiterplatte festgelegten erfindungsgemäßen Baugruppe.

### Beschreibung eines Ausführungsbeispiels

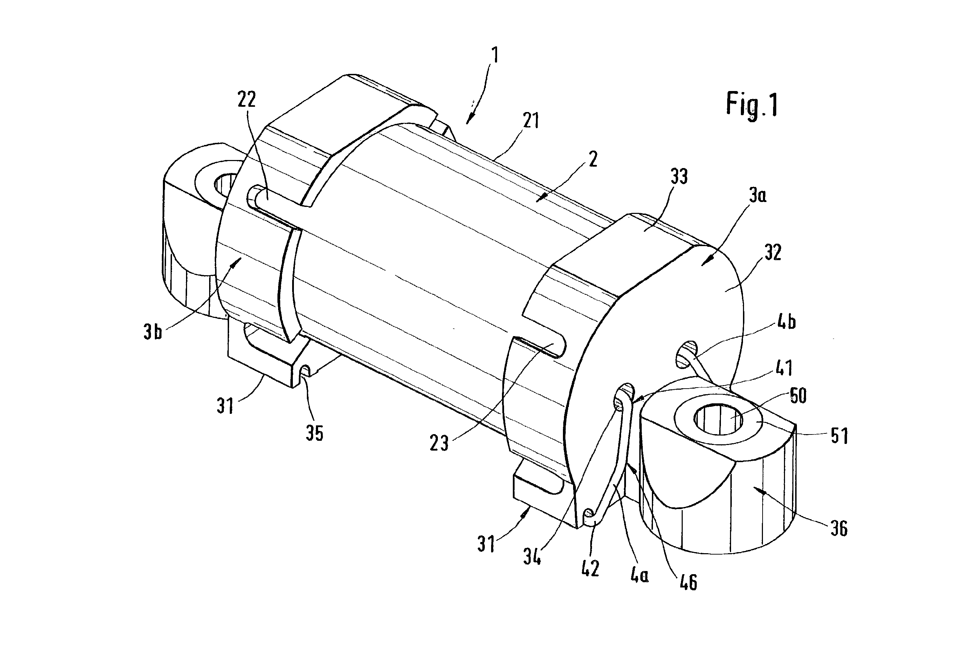

Fig. 1 zeigt ein Ausführungsbeispiel einer erfindungsgemäßen elektrischen Baugruppe 1, welche eine Haltevorrichtung 3a,3b und ein elektrisches Bauelement 2 umfaßt. Bei dem elektrischen Bauelement 2 handelt es sich um einen zylinderförmigen Kondensator mit einem langgestreckten Grundkörper 21 und stirnseitigen Enden 22,23, wobei an dem einen stirnseitigen Ende 23 zwei in Form von Drähten ausgebildete Anschlußelemente 4a,4b abstehen. Das elektrische Bauelement 2 kann aber auch ein anderes elektrisches Bauelement sein, beispielsweise ein Transistor, ein Widerstand oder ein anderes aktives oder passives Bauelement. Die Haltevorrichtung 3a,3b dient der mechanischen Befestigung des Bauelementes 2 auf einem Trägersubstrat, beispielsweise einer Leiterplatte oder einem Keramikträger, wobei die Anschlußelemente 4a,4b des elektrischen Bauelementes direkt mit zugeordneten Leiterbahnen des Trägersubstrats elektrisch verbunden werden können.

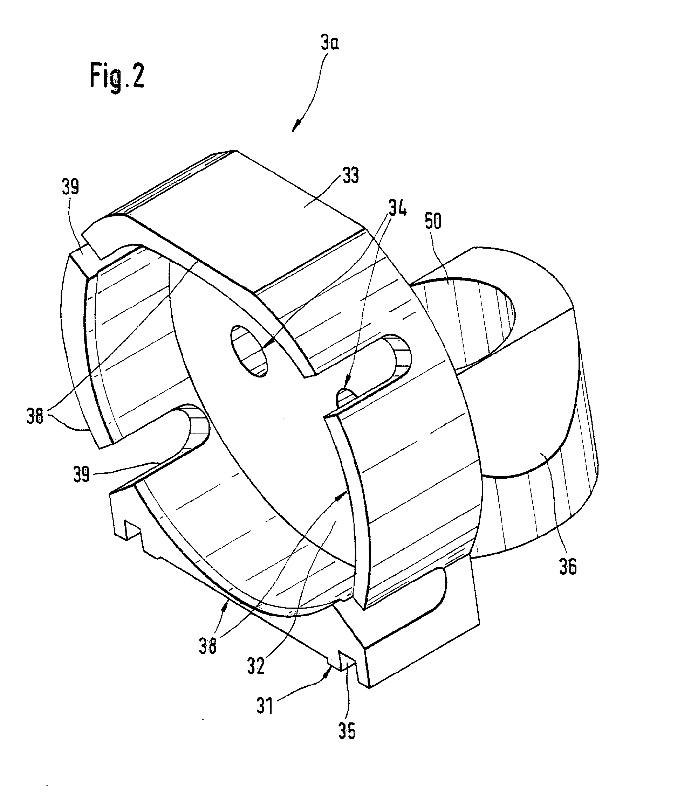

Wie in Fig. 1 und Fig. 2 zu erkennen ist, umfaßt die in diesem Ausführungsbeispiel dargestellte Haltevorrichtung zwei räumlich getrennte, gleichartig aufgebaute Halteteile 3a und 3b aus Kunststoff. Aber auch andere Materialien sind denkbar. Jedes der beiden Halteteile weist eine Stützfläche 31 zur Auflage auf das Trägersubstrat auf. Wie in Fig. 2 am besten zu erkennen ist, umfaßt ein Halteteil einen becherförmigen Grundkörper mit einer Grundplatte 32 und einer umlaufenden Seitenwand 33, welche durch schlitzartige Ausnehmungen 39 in mehrere elastisch biegsame Klemmlappen 38 unterteilt ist. Auf der von der becherförmigen Aufnahme für das Bauelement 2 abgewandten Seite der Grundplatte 32 ist ein Vorsprung 36 angeordnet, der mit einer Durchgangsöffnung 50 versehen ist. Die Durchgangsöffnung 50 erstreckt sich parallel zu der Grundplatte 32 und senkrecht zur Stützfläche 31, welche durch die ebene Unterseite eines Klemmlappen 38 und die Unterseite des Vorsprungs 36 gebildet wird. Die Durchgangsöffnung 50 kann durch eine Metallöse 51 verstärkt werden (Fig. 1). Bis auf die Metallöse 51 ist das Halteteil einstückig gefertigt. Die Grundplatte 32 weist weiterhin Durchbrüche 34 auf, welcher der Durchführung der Anschlußdrähte 4a,4b des Kondensator-Bauelementes 2 dienen.

Weiterhin sind an der Stützfläche 31 des Halteteils 3a zwei nutförmige Aussparungen 35 eingelassen, welche der Aufnahme von Endabschnitten der Anschlußdrähte des Bauelementes 2 dienen. Bei der Montage der Baugruppe 1 wird so verfahren, daß zunächst die beiden Halteteile 3a und 3b über die stirnseitigen Enden 22 und 23 des Bauelementes 2 geschoben werden. Dabei dringen die von der Stirnseite des Bauelementes abstehenden Anschlußdrähte 4a und 4b durch die beiden Durchbrüche 34 des Halteteils 3a. Die Klemmlappen 38 der beiden Halteteile 3a,3b umgreifen die Enden 22 und 23 des zylinderförmigen Bauelementes 2 und gelangen an der Mantelfläche zur Anlage. Durch die elastische Spannkraft der Klemmlappen 38 ist das Bauelement an den Halteteilen 3a und 3b zuverlässig festgelegt. Es ist aber auch möglich, das Bauelement mittels eines Klebers oder eines anderen Befestigungsmittels in den becherförmigen Halteteilen festzulegen. Die Anschlußdrähte werden anschließend einfach in der in Fig. 1 gezeigten Weise umgebogen, wobei jeder Anschlußdraht zunächst direkt hinter dem zugeordneten Durchbruch 38 durch eine erste Biegung 41 zur Stützfläche 31 hin abgebogen wird und in etwa auf der Höhe der Stützfläche 31 durch eine zweite Biegung 42 erneut derartig abgebogen wird, daß er mit seinem Endabschnitt parallel zur Stützfläche 31 in die Aussparung 35 eingreift. Durch einen zusätzlichen Knick 46 zwischen der ersten Biegung 41 und der zweiten Biegung 42 kann die federelastische Spannkraft des Anschlußdrahtes 4a,4b erhöht werden, was die Montage der Baugruppe auf einem Trägersubstrat erleichtert. Die Aussparung 35 und die Durchbrüche 34 in dem zweiten Halteteil 3b können auch entfallen. Jedoch ist vorgesehen, die beiden Halteteile 3a und 3b der Einfachheit halber als Spritzteile mit dem gleichen Werkzeug herzustellen. Sie sind daher in diesem Ausführungsbeispiel gleichartig aufgebaut.

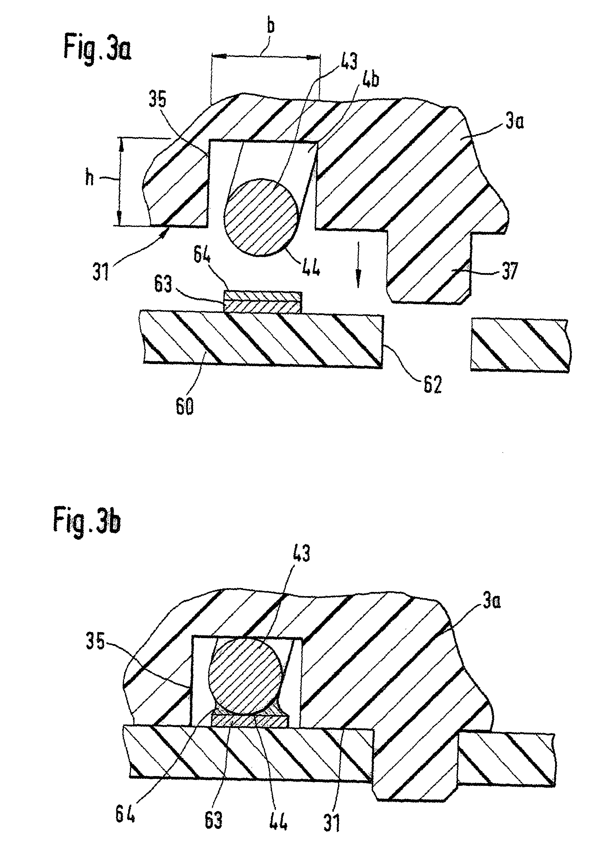

Fig. 3b zeigt in einer vergrößerten Detailansicht die Anordnung des Abschnitts 43 des Anschlußdrahtes 4b in der Aussparung 35 des Halteteils 3a. Wie zu erkennen ist, weist die Aussparung 35 eine Tiefe h und eine Breite b auf, die jeweils größer bemessen ist, als der Durchmesser des abgebogenen Abschnitts 43 des Anschlußdrahtes 4b. Der Abschnitt 43 steht mit einem Teil 44 von der Stützfläche 31 nach außen ab. Weiterhin ist ein Zentrierzapfen 37 an dem Halteteil 3a ausgebildet, der von der Stützfläche 31 senkrecht absteht.

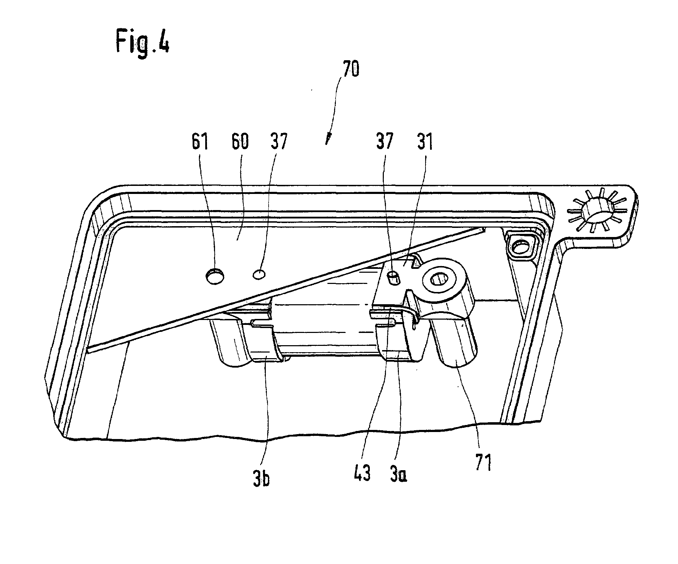

Bei der Bestückung der Baugruppe 1 auf einem Trägersubstrat 60 kann wie folgt verfahren werden. Zunächst werden die Leiterbahnen 63 des Trägersubstrats 60 mit Lotdepots 64 versehen. Anschließend wird die Baugruppe 1 mit den Halteteilen 3a,3b auf das Trägersubstrat 60 aufgesetzt, was mit einem automatischen SMD-Bestücker durchgeführt werden kann. Ebene Flächenstücke an der Oberseite der Seitenwand 33 der Halteteile dienen zur Aufnahme durch den Bestückungskopf eines Bestückers. Beim Aufsetzten auf das Trägersubstrat dringen die Zentrierzapfen 37 der beiden Halteteile 3a und 3b in Ausnehmungen 62 des Trägersubstrats 60 ein. Der parallel zur Stützfläche 31 abgebogene Abschnitt 43 der Anschlußdrähte 4a,4b gelangt mit dem Teil 44 an dem Lotdepot zur Anlage und wird in die Aussparung 35 gedrückt. Dies wird erleichtert, wenn die Anschlußdrähte 4a,4b elastisch biegsam ausgebildet sind. Durch den Knick 46 kann die Federwirkung der Anschlußdrähte 4a,4b noch vergrößert werden. In der Endlage gelangt die Stützfläche 31 an dem Trägersubstrat 60 zur Anlage, wie dies in Fig. 3b dargestellt ist. Der abgebogene Abschnitt 43, das Lotdepot 64 und die Leiterbahn 63 dringen in die Aussparung 35 ein. Durch beispielsweise einen Reflow-Lötprozeß können die Abschnitte 43 mit den Leiterbahnen 63 verlötet werden. Vorteilhaft werden die Halteteile 3a,3b dabei durch die Zentrierzapfen 37 in ihrer Position auf dem Trägersubstrat gehalten. Die Halteteile 3a, 3b können nun mittels Schrauben zusätzlich an dem Trägersubstrat 60 und/oder einem Gehäuseteil eines das Trägersubstrat bergenden Gehäuses befestigt werden, wie dies am besten in Fig. 4 zu erkennen ist. Fig. 4 zeigt eine geschnittene Darstellung durch ein Gehäuse 70 eines Steuergerätes für ein Kfz. Die Baugruppe 1 kann mittels durch die Ausnehmungen 61 des Trägersubstrats 60 geführten Schrauben an den Bolzen 71 des Gehäuses 70 und an der Leiterplatte 60 festgelegt werden. Beim Anziehen der Schrauben wird die Preßkraft von der Stützfläche 31 der Haltevorrichung vorteilhaft nur auf das Trägersubstrat 60 übertragen. Die in den Aussparungen 35 angeordneten Lötstellen 64 werden jedoch nicht belastet. Auf das Steuergerät 70 einwirkende Schütteloder Vibrationsbelastungen werden ebenfalls durch die stabile mechanische Befestigung der Baugruppe in dem Gehäuse aufgenommen und nicht auf die sensiblen Lötstellen übertragen.

Die Erfindung beschränkt sich jedoch nicht auf das hier dargestellte Ausführungsbeispiel. So ist es beispielsweise auch möglich die Halteteile 3a,3b anders auszugestalten. Insbesondere ist es möglich eine einstückige Haltevorrichtung oder eine Haltevorrichtung aus mehr als zwei Halteteilen zu verwenden. Weiterhin ist es möglich die Halteteile so auszugestalten, daß das elektrische Bauelement durch einen Spalt von der wenigstens einen Stützfläche beabstandet ist. In diesem Fall kann der Platz auf dem Trägersubstrat unterhalb des Bauelementes 2 für andere Bauelemente genutzt werden. Darüber hinaus ist vorstellbar, auf die Verlötung der Anschlußdrähte zu verzichten und die Anschlußdrähte nur über eine Klemmkontaktierung mit den Leiterbahnen des Trägersubstrats zu verbinden. Wichtig ist, daß die Anschlußelemente des elektrischen Bauelementes an der Haltevorrichtung derartig umgebogen sind, daß jeweils ein abgebogener Abschnitt des Anschlußelemente an der zur Auflage auf das Trägersubstrat vorgesehen Stützfläche der Haltevorrichtung angeordnet ist und so bei der Aufbringung der Baugruppe auf ein ebenes Trägersubstrat mit den Leiterbahnen beziehungsweise Kontaktflächen desselben kontaktiert werden kann.

## Patentansprüche

1. Elektrische Baugruppe (1), umfassend eine auf einem Trägersubstrat (60) mechanisch befestigbare Haltevorrichtung (3a,3b) mit wenigstens einer Stützfläche (31) zur Auflage auf das Trägersubstrat (60) und ein an der Haltevorrichtung (3a,3b) festgelegtes elektrisches Bauelement (2) mit wenigstens einem Anschlußelement (4a,4b), das mit einem an der wenigstens einen Stützfläche (31) angeordneten Kontaktteil der Baugruppe (1) elektrisch leitend verbunden ist, **dadurch gekennzeichnet, daß** das Kontaktteil durch einen abgebogenen Abschnitt (43) des wenigstens einen Anschlußelementes (4a,4b) des elektrischen Bauelementes (2) gebildet wird, welcher Abschnitt (43) an der Stützfläche (31) angeordnet ist.

2. Elektrische Baugruppe nach Anspruch 1, **dadurch gekennzeichnet, daß** die Haltevorrichtung (3a,3b) mittels schraubbaren Befestigungsmitteln an dem Trägersubstrat (60) mechanisch befestigbar ist.

3. Elektrische Baugruppe nach Anspruch 1 oder 2, **dadurch gekennzeichnet, daß** der abgebogene Abschnitt (43) des wenigstens einen Anschlußelementes (4a,4b) parallel zur Stützfläche (31) der Haltevorrichtung (3a,3b) verlaufend zumindest teilweise in einer Aussparung (35) der Stützfläche (31) angeordnet ist.

4. Elektrische Baugruppe nach Anspruch 3, **dadurch gekennzeichnet, daß** der abgebogene Abschnitt (31) des wenigstens einen Anschlußelementes (4a,4b) im nicht montierten Zustand der Baugruppe (1) mit einem Teil (44) ein Stück von der Stützfläche (31) nach außen absteht. (Fig. 3a)

5. Elektrische Baugruppe nach Anspruch 4, **dadurch gekennzeichnet, daß** der im nicht montierten Zustand der Baugruppe (1) von der Stützfläche (31) abstehende Teil (44) des abgebogenen Abschnitts (43) des wenigstens einen Anschlußelementes (4a,4b) bei Auflage auf das Trägersubstrat (60) in der Aussparung (35) versenkbar ist. (Fig. 3b)

6. Elektrische Baugruppe nach einem der Ansprüche 3 bis 5, **dadurch gekennzeichnet, daß** die Tiefe (h) und Breite (b) der Aussparung (35) größer bemessen ist als der Durchmesser des abgebogenen Abschnitts (43) des Anschlußelementes (4a,4b). (Fig. 3a)

7. Elektrische Baugruppe nach einem der Ansprüche 1 bis 6, **dadurch gekennzeichnet, daß** die Haltevorrichtung zwei räumlich getrennte Halteteile (3a,3b) mit jeweils einer Stützfläche (31) umfaßt und daß das elektrische Bauelemente (2) einen langgestreckten Grundkörper (21) mit zwei stirnseitigen Enden (22) aufweist, welche jeweils an einem Halteteil (3a,3b) der Haltevorrichtung befestigt sind.

8. Elektrische Baugruppe nach Anspruch 7, **dadurch gekennzeichnet, daß** die Halteteile (3a,3b) elastisch biegsame Klemmittel (38) zur Festlegung des elektrischen Bauelementes (2) aufweisen. (Fig. 2)

9. Elektrische Baugruppe nach Anspruch 7 oder 8, **dadurch gekennzeichnet, daß** jedes Halteteil (3a,3b) einen becherförmigen Grundkörper mit einer Grundplatte (32) und als elastisch biegsames Klemmittel eine umlaufende Seitenwand (33) aufweist.

10. Elektrische Baugruppe nach Anspruch 9, **dadurch gekennzeichnet, daß** die Seitenwände (33) wenigstens eines Halteteils (3a,3b) durch schlitzartige Ausnehmungen (39) in mehrere als elastisch biegsame Klemmmittel dienende Klemmlappen (38) unterteilt ist.

11. Elektrische Baugruppe nach einem der Ansprüche 7 bis 10, **dadurch gekennzeichnet, daß** jedes Halteteil (3a,3b) auf der von dem elektrischen Bauelement (2) abgewandten Seite einen Vorsprung (36) aufweist, der eine sich parallel zur Grundplatte (32) und senkrecht zur Stützfläche (31) des jeweiligen Halteteils erstreckende Durchgangsöffnung (50) zur Durchführung einer Schraube aufweist.

12. Elektrische Baugruppe nach einem der Ansprüche 7 bis 11, **dadurch gekennzeichnet, daß** jedes Halteteil (3a,3b) einen von der Stützfläche abstehenden Zentrierzapfen (37) zur Einführung in eine Ausnehmung (62) des Trägersubstrats (60) aufweist.

13. Elektrische Baugruppe nach einem der vorstehenden Ansprüche, **dadurch gekennzeichnet, daß** wenigstens ein Halteteil (3a) mit wenigstens einem Durchbruch (34) versehen ist, welcher der Durchführung des wenigstens einen von dem stirnseitigen Ende (23) des elektrischen Bauelementes (2) abstehenden Anschlußelementes (4a,4b) dient.

14. Elektrische Baugruppe nach Anspruch 13, **dadurch gekennzeichnet, daß** das wenigstens eine Anschlußelement hinter dem Durchbruch (34) zur Stützfläche (31) hin abgebogen ist und in der Ebene der Stützfläche (31) erneut abgebogen ist.

15. Elektrische Baugruppe nach einem der vorstehenden Ansprüche, **dadurch gekennzeichnet, daß** die Haltevorrichtung (3a,3b) aus Kunststoff gefertigt ist.

16. Elektrische Baugruppe nach einem der vorstehenden Ansprüche, **dadurch gekennzeichnet, daß** das elektrische Bauelement (2) ein Kondensator ist.

17. Trägersubstrat, insbesondere Leiterplatte, mit einer elektrischen Baugruppe nach einem der Ansprüche 1 bis 16.
